# FASCICULE DE BREVET EUROPEEN

(11) **EP 4 303 923 B1**
(45) Date de publication et mention de la délivrance du brevet: **19.02.2025**
(21) Numéro de dépôt: 23183362.5
(22) Date de dépôt: 04.07.2023
(51) Int. Cl.: H01L 23/58, G01R 33/06, G01R 33/12, G01R 33/14

(54) **PROCÉDÉ DE DÉTECTION D'ATTAQUE PAR ONDES ÉLECTROMAGNÉTIQUES D'UNE PUCE OU D'UN BOÎTIER-SYSTÈME BASÉ SUR L'EFFET GMI**
VERFAHREN ZUR DETEKTION EINES ANGRIFFS AUF EINEN CHIP ODER EIN SYSTEM-IN-PACKAGE DURCH ELEKTROMAGNETISCHE WELLEN AUF BASIS DES GMI-EFFEKTS
METHOD FOR DETECTING ELECTROMAGNETIC WAVE ATTACK ON A CHIP OR SYSTEM-IN-PACKAGE BASED ON THE GMI EFFECT

(30) Priorité: 05.07.2022 FR 2206850
(43) Date de publication de la demande: 10.01.2024
(73) Titulaire: Commissariat à l'Energie Atomique et aux Energies Alternatives, 75015 Paris (FR)
(72) Inventeur: SOHIER, Thibault, 38054 Grenoble cedex 09 (FR); BOREL, Stephan, 38054 Grenoble cedex 09 (FR); MICHEL, Jean-Philippe, 38054 Grenoble cedex 09 (FR)
(74) Mandataire: Brevalex

(56) Documents cités:
- FR-A1- 3 111 737
- BOREL STEPHAN ET AL: "Systems Secured by Packaging using a GMI Structure", 2021 SMART SYSTEMS INTEGRATION (SSI), IEEE, 27 April 2021 (2021-04-27), pages 1 - 4, XP033936450, DOI: 10.1109/SSI52265.2021.9466969

## Description

### DOMAINE TECHNIQUE

L'invention porte sur le domaine de la protection des puces électroniques et des boîtiers-systèmes électroniques, ou SiP (« System in Package » en anglais) contre les attaques physiques.

### État de la technique antérieure

Les attaques que peut subir une puce ou un SiP ont généralement pour but de perturber le fonctionnement d'un système ou d'accéder à des données confidentielles stockées dans la mémoire d'un circuit électronique de la puce ou du SiP. Une puce ou un SiP peut être attaqué de façon logicielle ou matérielle. Dans le second cas, les attaques, dites physiques, peuvent s'opérer de diverses manières : chimique, laser, électromagnétique, électrique, etc.

Les attaques par ondes électromagnétiques, qui consistent à réaliser une injection de fautes dans les composants (par exemple les transistors) des circuits de la puce ou du SiP attaqué via des impulsions électromagnétiques émises par une bobine d'une sonde d'attaque, sont dangereuses car généralement assez efficaces. Les ondes électromagnétiques sont émises par la bobine de la sonde d'attaque sous la forme de tirs de durée égale à quelques nanosecondes, ce qui génère des courants de Foucault perturbateurs dans les lignes de métallisation du circuit attaqué. Ces courants de Foucault provoquent le changement d'état de certains transistors et engendrent des erreurs dans les opérations exécutées dans le circuit attaqué, ce qui permet de contourner les sécurités cryptographiques mises en place dans ce circuit. Si ces opérations correspondent à des opérations de chiffrement/déchiffrement, il est possible, en analysant les valeurs erronées générées par le circuit, de retrouver des informations relatives à la clé de chiffrement (c'est-à-dire la valeur des bits qui la constituent) utilisée par le circuit attaqué.

Pour se protéger contre de telles attaques, il est possible d'utiliser une ou plusieurs bobines de détection disposées sur la puce ou le SiP. Ces bobines de détection sont utilisées au sein de circuits résonnants et détectent ces attaques grâce au couplage se produisant entre elles et la bobine de la sonde d'attaque car lorsque la bobine de la sonde d'attaque émet des ondes électromagnétiques, la fréquence d'oscillation des oscillateurs incluant les bobines de détection est alors modifiée. Les attaques sont détectées par mesure de cette variation de la fréquence d'oscillation de ces oscillateurs.

L'utilisation de telles bobines de détection n'assure toutefois une détection que pendant la durée de ces attaques.

### EXPOSÉ DE L'INVENTION

Un but de la présente invention est de proposer un procédé permettant a posteriori de détecter de manière fiable des attaques par ondes électromagnétiques qui ont été perpétrées sur une puce électronique ou un boîtier-système électronique.

Pour cela, l'invention propose un procédé de détection d'attaque par ondes électromagnétiques sur un dispositif de type puce ou boîtier-système électronique comportant au moins un élément de détection d'attaque, ledit élément de détection d'attaque comportant au moins un matériau électriquement conducteur à effet de magnéto-impédance géante, GMI, comportant au moins les étapes suivantes :
a) démagnétisation du matériau électriquement conducteur à effet GMI telle que la valeur de son aimantation rémanente soit égale à une valeur prédéfinie inférieure à la valeur de son aimantation rémanente maximale,
b) détermination d'une première valeur de l'impédance de l'élément de détection d'attaque pour une valeur donnée de fréquence d'un courant alternatif circulant dans le matériau électriquement conducteur à effet GMI, puis
c) après une durée pendant laquelle le dispositif est susceptible d'avoir subi une attaque par ondes électromagnétiques, mesure d'une deuxième valeur de l'impédance de l'élément de détection d'attaque en faisant circuler dans le matériau électriquement conducteur à effet GMI un courant alternatif de fréquence égale à ladite valeur donnée,
d) comparaison des première et deuxième valeurs de l'impédance de l'élément de détection d'attaque, le dispositif étant considéré comme ayant subi une attaque par ondes électromagnétiques lorsque les première et deuxième valeurs de l'impédance de l'élément de détection d'attaque sont significativement différentes l'une de l'autre.

Dans ce procédé, il est proposé de fixer tout d'abord un état initial de l'aimantation rémanente d'un matériau électriquement conducteur à effet GMI à un niveau inférieur à l'aimantation rémanente maximale atteignable par ce matériau. Ainsi, toute attaque par ondes électromagnétiques perpétrée sur le dispositif va engendrer une réorientation de certains domaines de Weiss du matériau électriquement conducteur à effet GMI de façon importante et durable, modifiant ainsi fortement son aimantation rémanente et donc également son impédance. Grâce aux mesures d'impédance réalisées avant et après une certaine durée pendant laquelle le dispositif est susceptible de subir une attaque, il devient donc possible de déterminer de manière très fiable si le dispositif a subi une attaque par ondes électromagnétiques.

Un des avantages apportés par l'effet GMI est qu'une variation importante de l'impédance de l'élément de détection d'attaque du dispositif est obtenue de façon durable même lorsque l'aimantation de cet élément varie faiblement.

L'effet GMI obtenu correspond à une modification durable de l'aimantation du matériau électriquement conducteur présentant un tel effet, lorsqu'il est soumis à un champ magnétique extérieur qui dépend du matériau utilisé et qui est par exemple de l'ordre de 1 Oe ou 80 A/m, ou compris entre environ 1 Oe et 100 Oe (soit 0,1 mT et 10 mT) pouvant être mise à profit lors d'une mesure a posteriori de son impédance. L'aimantation peut être considérée comme étant durablement modifiée lorsque sa valeur ne change pas jusqu'à ce qu'elle soit de nouveau modifiée par magnétisation ou démagnétisation.

L'amplitude du courant alternatif utilisé lors des mesures d'impédance est par exemple comprise entre 5 mA et 300 mA, ou entre 10 mA et 300 mA, ou entre 20 mA et 300 mA, et sa fréquence est par exemple de l'ordre de quelques kHz jusqu'à plusieurs GHz, par exemple comprise entre 1 kHz et 10 GHz.

Les première et deuxième valeurs de l'impédance de l'élément de détection d'attaque peuvent être considérées comme étant significativement différentes l'une de l'autre lorsque la deuxième valeur diffère d'au moins 5% par rapport à la première valeur.

Un boîtier-système électronique, ou SiP, correspond à un ensemble de puces électroniques, circuits intégrés ou autres composants (passifs, MEMS, etc...) enfermés dans un même boîtier ou module, ces puces étant disposées les unes à côté des autres et/ou les unes au-dessus des autres, sur un support, et connectées électriquement entre elles et à des connexions extérieures au boîtier par des fils et/ou par flip-chip (ou puce retournée).

Le matériau magnétique électriquement conducteur à effet GMI peut correspondre à un matériau présentant les propriétés suivantes :
- qu'il soit ferromagnétique doux, c'est-à-dire qui soit facilement magnétisable, avec un cycle d'hystérésis étroit et un champ coercitif Hc inférieur ou égal à 10 Oe ;
- dont la perméabilité magnétique relative soit supérieure ou égale à 10.

L'étape a) peut être mise en œuvre en faisant circuler dans le matériau électriquement conducteur à effet GMI un courant alternatif d'excitation dont l'amplitude diminue progressivement dans le temps ou en soumettant le matériau électriquement conducteur à effet GMI à un champ d'excitation magnétique dont l'amplitude diminue progressivement dans le temps, jusqu'à ce que la valeur de l'aimantation rémanente du matériau électriquement conducteur à effet GMI soit égale à la valeur prédéfinie.

Dans une première configuration, la valeur prédéfinie peut être égale à la valeur de l'aimantation rémanente minimale du matériau électriquement conducteur à effet GMI. Un des avantages d'une telle mise en œuvre du procédé est que la moindre modification de l'aimantation du matériau électriquement conducteur à effet GMI est alors détectée, ce qui permet d'avoir la plus grande sensibilité possible pour détecter les potentielles attaques par ondes électromagnétiques.

Dans une deuxième configuration, la valeur prédéfinie peut être supérieure à la valeur de l'aimantation rémanente minimale du matériau électriquement conducteur à effet GMI. Un des avantages d'une telle mise en œuvre du procédé est qu'étant donné le caractère inconnu, pour un attaquant, de la valeur prédéfinie, il n'est pas possible pour cet attaquant de réaliser, après une attaque, une démagnétisation du matériau électriquement conducteur à effet GMI dans le but de restaurer ce matériau dans son état initial.

Le matériau électriquement conducteur à effet GMI peut être avantageusement un matériau ferromagnétique doux.

L'élément de détection peut former un capteur localisé au niveau d'une partie d'une face du dispositif.

Dans ce cas, le dispositif peut comporter en outre au moins un élément de protection de ladite face du dispositif, ledit élément de protection étant disposé dans le dispositif et comprenant au moins une autre portion de matériau électriquement conducteur à effet GMI (qui peut être similaire ou non au matériau électriquement conducteur à effet GMI de l'élément de détection d'attaque) s'étendant, dans un plan parallèle à ladite face du dispositif, selon au moins un motif de serpentin et/ou de spirale.

Ainsi, l'élément de détection peut correspondre à un capteur GMI de dimensions inférieures à la zone à protéger et qui peut être associé ici à un élément de protection pouvant occuper toute la surface du dispositif à protéger et former un écran de protection, par exemple vis-à-vis d'attaque par laser, mais qui peut également, dans le cas d'une attaque par ondes électromagnétiques, voir une partie de sa longueur magnétisée et ainsi informer le capteur GMI d'une attaque, même *a posteriori.*

Cet élément de protection peut être disposé en regard d'une région du dispositif à protéger de manière à ce qu'une attaque ne puisse être mise en œuvre sans retirer ou modifier cet élément de protection pour pouvoir accéder à cette région du dispositif. Certaines attaques peuvent notamment modifier l'impédance de l'élément de protection de manière irréversible, rendant impossible la restauration de cette valeur d'impédance après l'attaque.

L'élément de protection du dispositif permet donc de détecter une modification de l'environnement électromagnétique du dispositif, conférant une bonne protection du dispositif notamment vis-à-vis des attaques électromagnétiques, ainsi que toute modification de la structure de l'élément de protection, conférant une bonne protection du dispositif vis-à-vis des attaques laser ou autres attaques nécessitant un accès au composant. En outre, les matériaux utilisés pour former l'élément de protection agissent comme un bouclier, ou blindage, vis-à-vis des ondes électromagnétiques, ce qui contribue à protéger le dispositif.

Le dispositif peut comporter en outre au moins un deuxième élément de détection d'attaque du dispositif comprenant au moins un deuxième matériau électriquement conducteur à effet GMI (qui peut être similaire ou non au matériau électriquement conducteur à effet GMI de l'autre élément de détection d'attaque), et dans lequel les étapes a), b), c) et d) du procédé sont également mises en œuvre pour le deuxième élément de détection d'attaque. Etant donné que chaque élément de détection d'attaque peut avoir une région de détection limitée, avoir plusieurs éléments de détection d'attaque peut permettre de couvrir tout la surface à protéger du dispositif.

Les premier et deuxième éléments de détection d'attaque peuvent être disposés sur une même face du dispositif.

Le dispositif peut comporter une mémoire, un FPGA (« Field Programmable Gate Array » en anglais, ou circuit logique programmable) ou un ASIC (« Application-Specific Integrated Circuit », ou circuit intégré spécialisé) comprenant par exemple un processeur ainsi que d'autres composants tels que des composants passifs, des capteurs, etc.

Le dispositif peut comporter un matériau d'encapsulation recouvrant au moins l'élément de détection d'attaque du dispositif, et/ou recouvrant l'élément de protection.

Le matériau électriquement conducteur à effet GMI peut correspondre à un métal, ou un alliage métallique, comprenant au moins l'un des éléments suivants : Fe, Ni, Co.

Le dispositif peut comporter en outre :
- un dispositif de lecture d'impédance de l'élément de détection d'attaque du dispositif ;
- une mémoire dans laquelle la première valeur de l'impédance de l'élément de détection d'attaque du dispositif est destinée à être stockée.

Une source de courant alternatif peut être couplée électriquement à l'élément de détection d'attaque du dispositif. Cette source de courant peut être externe au dispositif.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
La Fig.1 représente schématiquement un premier exemple de réalisation d'un dispositif comportant un élément de détection d'attaque avec lequel un procédé de détection d'attaque par ondes électromagnétiques, objet de la présente invention, est mis en œuvre ;
La Fig. 2 représente schématiquement un exemple de courant d'excitation appliqué sur un matériau électriquement conducteur à effet GMI lors d'une démagnétisation de ce matériau ;
La Fig. 3 représente un exemple de variation de la valeur de l'aimantation d'un matériau électriquement conducteur à effet GMI lorsque celui-ci est soumis à un courant, ou champ, d'excitation lors d'une démagnétisation de ce matériau ;
La Fig. 4 représente des mesures d'impédance de l'élément de détection d'attaque réalisées pour différents états d'aimantation du matériau électriquement conducteur à effet GMI de cet élément avec lequel le procédé de détection d'attaque par ondes électromagnétiques, objet de la présente invention, est mis en œuvre ;
La Fig. 5, et la Fig. 6 représentent schématiquement des deuxième et troisième exemples de réalisation d'un dispositif comportant un élément de détection d'attaque avec lequel un procédé de détection d'attaque par ondes électromagnétiques, objet de la présente invention, est mis en œuvre.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSE DETAILLE DE MODES DE REALISATION PARTICULIERS

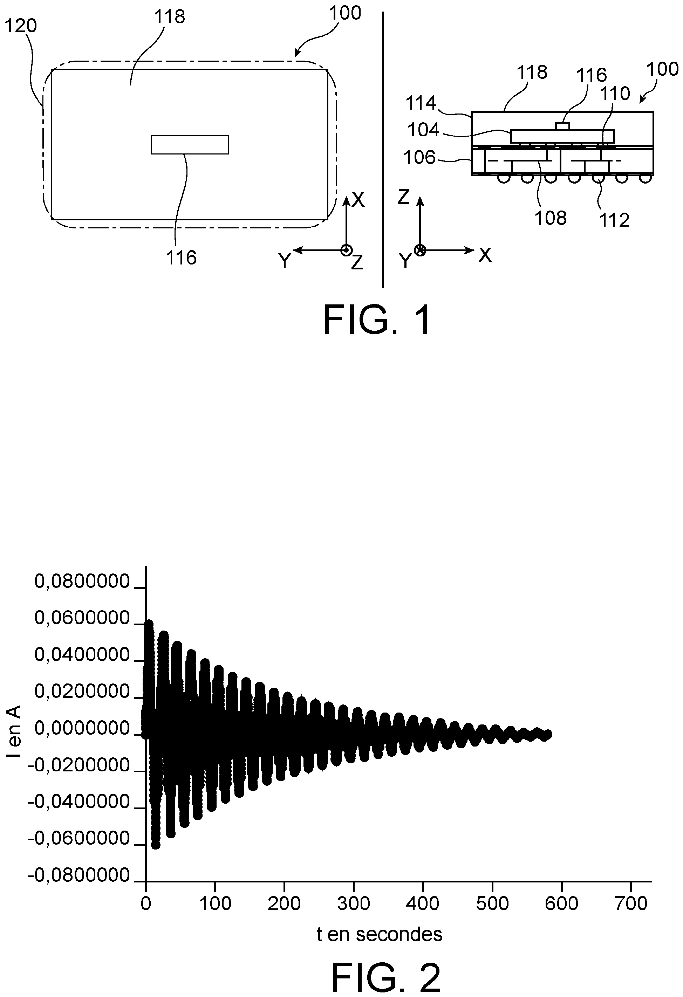

La figure 1 représente schématiquement un exemple de réalisation d'un dispositif 100 muni d'au moins un élément de détection d'attaque avec lequel un procédé de détection d'attaque par ondes électromagnétiques est mis en œuvre. Sur la figure 1, la vue de gauche correspond à une vue de dessus du dispositif 100, et la vue de droite correspond à une vue en coupe du dispositif 100.

Le dispositif 100 correspond ici à un boîtier-système électronique, ou SiP. Le dispositif 100 comporte une ou plusieurs puces 104 (une seule puce 104 est représentée dans l'exemple de la figure 1) et un support 106 sur lequel la ou les puces 104 sont couplées mécaniquement et électriquement. Le dispositif 100 peut également comporter d'autres composants électroniques disposés sur le support 106. Le support 106 forme la face arrière du dispositif 100. Le support 106 correspond par exemple à un substrat organique ou céramique ou métallique.

Le dispositif 100 comporte également une ou plusieurs couches métalliques de redistribution 108 (ou RDL pour « Redistribution Layer ») disposée sur et/ou dans le support 106 et à laquelle des connexions électriques 110, correspondant par exemple à des microbilles, de la ou des puces 104 sont couplées mécaniquement et électriquement (couplage de type flip chip sur l'exemple de la figure 1 ; un couplage par câblage filaire est également possible). Certaines portions de la couche métallique de redistribution 108 sont reliées électriquement, à travers le support 106, à des broches de connexion 112 du dispositif 100 qui correspondent par exemple à des billes de connexions. Une ou plusieurs autres portions de la couche métallique de redistribution 108 peuvent relier électriquement entre elles des connexions électriques 110. La couche métallique de redistribution 108 comporte par exemple l'un des matériaux suivants : Cu, Au, Al.

Le dispositif 100 comporte également un matériau d'encapsulation 114 entourant la puce 104. Ce matériau d'encapsulation 114 est notamment destiné à protéger mécaniquement la puce 104. Le matériau d'encapsulation 114 comporte par exemple une résine époxy chargée en billes de silice.

Le dispositif 100 comporte un élément 116 de détection d'attaque du dispositif 100 qui est, dans l'exemple de la figure 1, disposé sur la puce 104, du côté opposé à celui où se trouvent les broches de connexion 112 et relié électriquement au substrat 106 afin de transmettre l'information selon laquelle une attaque a été réalisée ou non. Le matériau d'encapsulation 114 englobé également l'élément 116, et du matériau d'encapsulation est présent entre l'élément 116 et la puce 104. Cet élément 116 comporte au moins un matériau électriquement conducteur à effet GMI. Dans l'exemple de réalisation décrit en lien avec la figure 1, l'élément 116 comporte une portion de matériau électriquement conducteur à effet GMI formant un capteur localisé au niveau d'une partie d'une face 118 du dispositif 100 qui correspond ici à la face supérieure du dispositif 100 qui est opposée à celle où se trouvent les broches de connexion 112. Sur la vue de gauche de la figure 1, une région 120 délimitée par des traits pointillés représente symboliquement la zone de sensibilité de l'élément 116, c'est-à-dire la zone dans laquelle des ondes électromagnétiques liées à une attaque du dispositif 100 sont susceptibles d'affecter l'élément 116 et donc d'être détectées.

Selon un exemple de réalisation, le matériau électriquement conducteur ayant un effet GMI de l'élément 116 correspond à un matériau ferromagnétique doux, tel qu'un métal ou un alliage métallique comportant au moins l'un des éléments suivants : Fe, Ni, Co, et par exemple du NiFe et/ou CoTaZr. Le matériau de l'élément 116 peut également correspondre à un polymère conducteur ou à du carbone conducteur.

Au cours d'une première étape a), le matériau électriquement conducteur à effet GMI de l'élément 116 est démagnétisé de sorte que la valeur de l'aimantation rémanente de ce matériau, c'est-à-dire son aimantation lorsqu'il n'est pas soumis à un champ magnétique extérieur, soit égale à une valeur prédéfinie inférieure à la valeur de l'aimantation rémanente maximale de ce matériau.

Pour réaliser cette démagnétisation, il est par exemple possible de faire circuler dans le matériau électriquement conducteur à effet GMI de l'élément 116 un courant alternatif d'excitation dont l'amplitude diminue progressivement dans le temps ou de soumettre le matériau électriquement conducteur à effet GMI à un champ d'excitation magnétique dont l'amplitude diminue progressivement dans le temps, jusqu'à ce que la valeur de l'aimantation rémanente du matériau électriquement conducteur à effet GMI soit égale à ladite valeur prédéfinie. La figure 2 représente schématiquement un exemple d'évolution de l'amplitude en fonction du temps d'un tel courant d'excitation circulant dans le matériau électriquement conducteur à effet GMI de l'élément 116 lors d'une telle démagnétisation de ce matériau. Lorsque la démagnétisation est réalisée en utilisant un champ magnétique d'excitation, la forme du signal représentant l'évolution de l'amplitude de ce champ magnétique d'excitation en fonction du temps peut être sensiblement similaire à celle du signal représenté sur la figure 2.

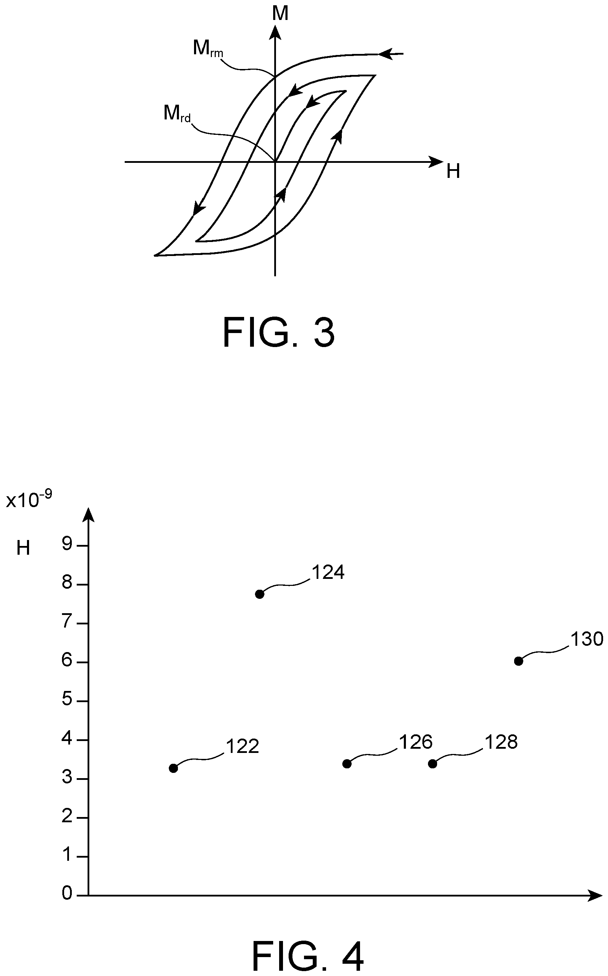

La figure 3 représente la variation de la valeur de l'aimantation du matériau électriquement conducteur à effet GMI de l'élément 116 lorsque celui-ci est soumis à un courant d'excitation ou un champ magnétique d'excitation lors de cette démagnétisation. La valeur Mᵣₘ correspond à la valeur de l'aimantation rémanente du matériau électriquement conducteur à effet GMI de l'élément 116 avant la mise en œuvre de cette étape de démagnétisation. La valeur M_{rd} correspond à la valeur de l'aimantation rémanente du matériau électriquement conducteur à effet GMI de l'élément 116 après la mise en œuvre de cette étape de démagnétisation.

Dans l'exemple de réalisation décrit ici, cette démagnétisation est mise en œuvre telle que la valeur de l'aimantation rémanente du matériau électriquement conducteur à effet GMI de l'élément 116 (M_{rd} sur la figure 3) soit égale à la valeur de l'aimantation rémanente minimale de ce matériau. Autrement dit, le courant d'excitation ou le champ magnétique d'excitation appliqué lors de cette démagnétisation diminue progressivement de manière à réduire progressivement l'aimantation du matériau électriquement conducteur à effet GMI de l'élément 116 jusqu'à atteindre la plus petite valeur possible pour ce matériau. En variante, il est possible que la valeur prédéfinie à laquelle l'aimantation rémanente du matériau électriquement conducteur à effet GMI de l'élément 116 est fixée soit supérieure à la valeur de son aimantation rémanente minimale, mais toujours inférieure à la valeur de son aimantation rémanente maximale. Il est possible de choisir cette valeur d'aimantation rémanente du matériau électriquement conducteur à effet GMI de l'élément 116 en stoppant l'application du courant d'excitation ou du champ magnétique d'excitation au moment où la valeur d'aimantation rémanente souhaitée est atteinte dans ce matériau.

Après cette étape de démagnétisation, une deuxième étape b) est mise en œuvre pour déterminer une première valeur d'impédance de l'élément 116 pour une valeur donnée de fréquence d'un courant alternatif circulant dans le matériau électriquement conducteur à effet GMI de l'élément 116. Cette étape est par exemple réalisée en mesurant cette impédance aux bornes de la portion de matériau électriquement conducteur à effet GMI de l'élément 116. La valeur d'impédance déterminée peut correspondre à celle d'une impédance réelle ou d'une impédance complexe.

Après avoir déterminé la valeur de l'impédance de l'élément 116 lorsque la valeur de l'aimantation rémanente du matériau électriquement conducteur à effet GMI est égale à la valeur prédéfinie, le dispositif 100 est prêt à être utilisé et/ou stocké pendant une durée. Pendant cette durée, le dispositif 100 est susceptible de subir une attaque par ondes électromagnétiques.

Après cette durée, pouvant représenter plusieurs minutes, ou plusieurs heures, ou plusieurs jours, ou plusieurs mois, voire plusieurs années, une troisième étape c) de mesure de la valeur d'impédance de l'élément 116 est mise en œuvre en faisant circuler dans le matériau électriquement conducteur à effet GMI de l'élément 116 un courant alternatif de fréquence égale à celle utilisée lors de la précédente étape b). En comparant ensuite, lors d'une quatrième étape d), les deux valeurs d'impédance mesurées, la première avant la durée pendant laquelle le dispositif 100 est susceptible de subir une attaque par ondes électromagnétiques et la deuxième après cette durée, il est possible de déterminer si le dispositif 100 a subi ou non une telle attaque, le dispositif 100 étant considéré comme ayant été attaqué lorsque les première et deuxième valeurs de l'impédance de l'élément de détection sont significativement différentes l'une de l'autre, c'est-à-dire avec par exemple une différence d'au moins 5% de la deuxième valeur par rapport à la première valeur.

La figure 4 représente des mesures d'impédance de l'élément 116 réalisées pour différents états d'aimantation du matériau électriquement conducteur à effet GMI de l'élément 116.

La mesure 122 correspond à la valeur de l'inductance initiale de l'élément 116 avant qu'il soit démagnétisé.

La mesure 124 représente la valeur de l'inductance de l'élément 116 lorsque celui-ci est totalement magnétisé.

La mesure 126 représente la valeur de l'inductance de l'élément 116 après avoir subi une démagnétisation telle que la valeur de l'aimantation rémanente du matériau électriquement conducteur à effet GMI de l'élément 116 soit égale à la valeur de l'aimantation rémanente minimale de ce matériau.

La mesure 128 représente la valeur de l'inductance de l'élément 116 après avoir subi une attaque par ondes électromagnétiques avec une sonde disposée à une distance égale à environ 10 mm de l'élément 116. Une telle attaque ne permet pas de réaliser une injection de fautes dans le dispositif car la sonde est trop éloignée du dispositif 100. Les mesures 126 et 128 montrent qu'une telle attaque de modifie pas significativement l'aimantation de l'élément 116 car les valeurs mesurées sont très proches l'une de l'autre.

La mesure 130 représente la valeur de l'inductance de l'élément 116 après avoir subi une attaque par ondes électromagnétiques avec une sonde disposée à une distance égale à environ 5 mm de l'élément 116. Cette mesure montre que de telles attaques, qui sont susceptibles d'engendrer des fautes dans le dispositif 100, modifient sensiblement l'aimantation de l'élément 116, et que ces modifications sont ensuite détectables par une mesure d'impédance de l'élément 116.

Toutes ces mesures sont réalisées en faisant circuler dans le matériau électriquement conducteur à effet GMI de l'élément 116 un courant sinusoïdal de fréquence égale à 70 MHz.

La fréquence du signal lors des mesures d'impédance est par exemple comprise entre 1 kHz et 10 GHz, voire entre 70 MHz et 500 MHz. Lorsque la fréquence du signal est importante, par exemple supérieure à environ 100 MHz, il est intéressant de prendre en compte les valeurs de la résistance de l'élément 116 pour déterminer si le dispositif 100 a subi une attaque. Dans le cas contraire, il est préférable de prendre en compte les valeurs de l'inductance de l'élément 116 pour déterminer si le dispositif 100 a subi une attaque.

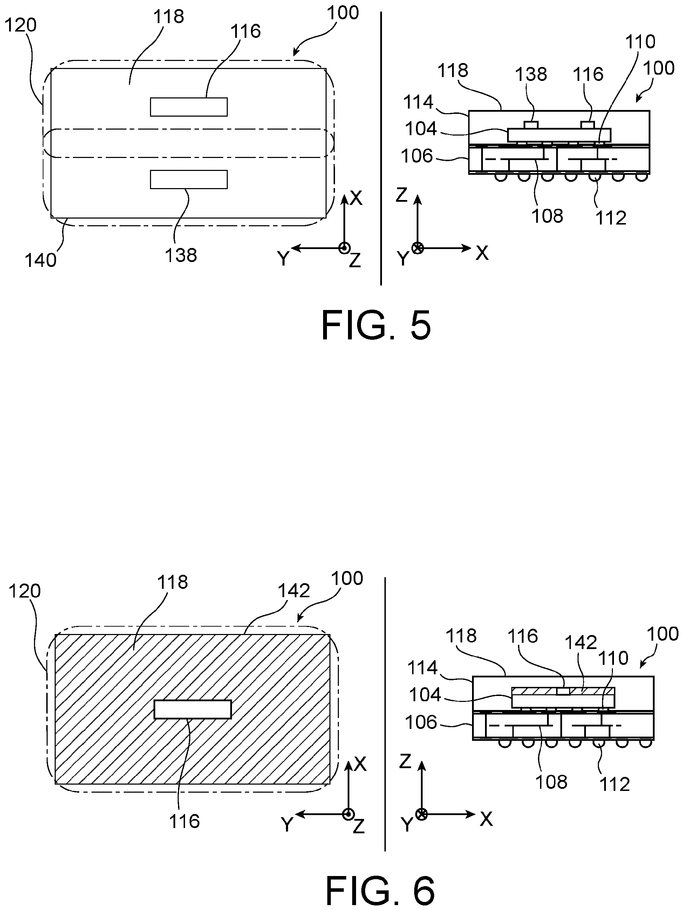

La figure 5 représente schématiquement un deuxième exemple de réalisation d'un dispositif 100 muni d'au moins un élément de détection d'attaque avec lequel un procédé de détection d'attaque par ondes électromagnétiques est mis en œuvre.

Par rapport au dispositif 100 précédemment décrit en lien avec la figure 1, le dispositif 100 représenté sur la figure 5 comporte, en plus du premier élément 116, un deuxième élément 138 de détection d'attaque du dispositif 100. Ce deuxième élément 138 comporte au moins une portion de matériau électriquement conducteur à effet GMI, ce matériau pouvant être similaire ou non à celui du premier élément 116. Sur la vue de gauche de la figure 5, une région 140 délimitée par des traits pointillés représente symboliquement la zone de sensibilité du deuxième élément 138, c'est-à-dire la zone dans laquelle des ondes électromagnétiques liées à une attaque du dispositif 100 sont susceptibles d'affecter l'élément 138 et donc d'être détectées. Les régions 120 et 140 couvrent ensemble la totalité de la face 118 du dispositif 100.

La figure 6 représente schématiquement un troisième exemple de réalisation d'un dispositif 100 muni d'au moins un élément de détection d'attaque avec lequel un procédé de détection d'attaque par ondes électromagnétiques est mis en œuvre.

Par rapport au dispositif 100 précédemment décrit en lien avec la figure 1, le dispositif 100 représenté sur la figure 6 comporte, en plus du premier élément 116, au moins un élément de protection 142 d'au moins une face 118 du dispositif 100. Sur la figure 6, l'élément de protection 142 est représenté avec des hachures. Dans l'exemple de réalisation représenté sur la figure 6, l'élément de protection 142 protège toute la surface de la puce 104 se trouvant du côté de la face 118 et est disposé au-dessus de la puce 104, dans le matériau d'encapsulation 114.

L'élément de protection 142 comporte un élément de détection d'attaque du dispositif 100 comportant au moins un matériau électriquement conducteur à effet GMI.

Dans un exemple de réalisation, l'élément de protection 142 peut comporter des portions connectées électriquement de matériau électriquement conducteur ayant un effet GMI formant une couche de protection localisée du côté d'au moins l'une des faces de la puce 104 (du côté de la face 118 dans l'exemple représenté sur la figure 6), protégeant ainsi la puce 104 vis-à-vis d'attaques menées depuis le côté du dispositif 100 au niveau duquel se trouve cet élément de protection 142. Cet élément de protection peut s'étendre du côté de la face 118, dans un plan parallèle à la face 118, selon un motif d'un ou plusieurs serpentins, c'est-à-dire peut comporter de nombreuses portions reliées entre elles en formant des coudes et des chicanes afin de former un motif complexe et difficilement identifiable. Des motifs autres qu'un ou plusieurs serpentins sont possibles, comme par exemple des motifs de spirales.

De nombreux détails et variantes de réalisation de l'élément de protection 142 sont décrits dans la demande FR 3 111 737 A1 et sont applicables pour la réalisation d'un tel élément de protection 142 combiné au procédé de détection d'attaque selon l'invention.

Dans tous les exemples de réalisation, le dispositif 100 peut comporter un dispositif de lecture d'impédance du ou des éléments de détection d'attaque 116, 138, 142 et une mémoire dans laquelle au moins une valeur de référence de l'impédance du ou de chacun de ces éléments 116, 138, 142 est stockée. Une source de courant alternatif externe au dispositif 100 est couplée électriquement à ou aux éléments de détection 116, 138, 142 telle que ce courant circule dans ce ou ces éléments 116, 138, 142 lors d'une mesure d'impédance de ce ou ces éléments 116, 138, 142.

## Revendications

1. Procédé de détection d'attaque par ondes électromagnétiques sur un dispositif (100) de type puce ou boîtier-système électronique comportant au moins un élément (116) de détection d'attaque du dispositif (100), ledit élément (116) de détection d'attaque comportant au moins un matériau électriquement conducteur à effet de magnéto-impédance géante, GMI, comportant au moins les étapes suivantes :
a) démagnétisation du matériau électriquement conducteur à effet GMI telle que la valeur M_{rd} de son aimantation rémanente soit égale à une valeur prédéfinie inférieure à la valeur de son aimantation rémanente maximale,
b) détermination d'une première valeur de l'impédance de l'élément de détection d'attaque (116) pour une valeur donnée de fréquence d'un courant alternatif circulant dans le matériau électriquement conducteur à effet GMI, puis
c) après une durée pendant laquelle le dispositif (100) est susceptible d'avoir subi une attaque par ondes électromagnétiques, mesure d'une deuxième valeur de l'impédance de l'élément de détection d'attaque (116) en faisant circuler dans le matériau électriquement conducteur à effet GMI un courant alternatif de fréquence égale à ladite valeur donnée,
d) comparaison des première et deuxième valeurs de l'impédance de l'élément de détection d'attaque (116), le dispositif (100) étant considéré comme ayant subi une attaque par ondes électromagnétiques lorsque les première et deuxième valeurs de l'impédance de l'élément de détection d'attaque (116) sont significativement différentes l'une de l'autre.

2. Procédé selon la revendication 1, dans lequel l'étape a) est mise en œuvre en faisant circuler dans le matériau électriquement conducteur à effet GMI un courant alternatif d'excitation dont l'amplitude diminue progressivement dans le temps ou en soumettant le matériau électriquement conducteur à effet GMI à un champ d'excitation magnétique dont l'amplitude diminue progressivement dans le temps, jusqu'à ce que la valeur de l'aimantation rémanente du matériau électriquement conducteur à effet GMI soit égale à ladite valeur prédéfinie.

3. Procédé selon l'une quelconque des revendications précédentes, dans lequel la valeur prédéfinie est égale à la valeur de l'aimantation rémanente minimale du matériau électriquement conducteur à effet GMI.

4. Procédé selon l'une quelconque des revendications 1 ou 2, dans lequel la valeur prédéfinie est supérieure à la valeur de l'aimantation rémanente minimale du matériau électriquement conducteur à effet GMI.

5. Procédé selon l'une quelconque des revendications précédentes, dans lequel le matériau électriquement conducteur à effet GMI est un matériau ferromagnétique doux.

6. Procédé selon l'une quelconque des revendications précédentes, dans lequel l'élément de détection d'attaque (116) forme un capteur localisé au niveau d'une partie d'une face (118) du dispositif (100).

7. Procédé selon la revendication 6, dans lequel le dispositif (100) comporte en outre au moins un élément de protection (142) de ladite face (118) du dispositif (100), ledit élément de protection (142) étant disposé dans le dispositif (100) et comprenant au moins une autre portion de matériau électriquement conducteur à effet GMI s'étendant, dans un plan parallèle à ladite face (118) du dispositif (100), selon au moins un motif de serpentin et/ou de spirale.

8. Procédé selon l'une quelconque des revendications précédentes, dans lequel le dispositif (100) comporte en outre au moins un deuxième élément de détection d'attaque (138) du dispositif (100) comprenant au moins un deuxième matériau électriquement conducteur à effet GMI, et dans lequel les étapes a), b), c) et d) du procédé sont également mises en œuvre pour le deuxième élément de détection d'attaque (138).

9. Procédé selon les revendications 6 et 8 ou selon les revendications 7 et 8, dans lequel les premier et deuxièmes éléments de détection d'attaque (116, 138) sont disposés sur ladite face (118) du dispositif (100).

## Patentansprüche

1. Verfahren zum Erkennen eines Angriffs durch elektromagnetische Wellen auf ein Gerät (100) vom Chip-Typ oder vom Gehäuse-Typ eines elektronischen Systems, das mindestens ein Element (116) zum Erkennen eines Angriffs auf das Gerät (100) umfasst, wobei das Element (116) zum Erkennen eines Angriffs mindestens ein elektrisch leitendes Material mit Riesenmagneto-Impedanz-Effekt, GMI, umfasst, das mindestens die folgenden Schritte umfasst:
a) Entmagnetisieren des elektrisch leitenden Materials mit GMI-Effekt derart, dass der M_{rd}-Wert seiner remanenten Magnetisierung gleich einem vorbestimmten Wert ist, der kleiner ist als der Wert seiner maximalen remanenten Magnetisierung,
b) Bestimmen eines ersten Werts der Impedanz des Angriffserkennungselements (116) für einen gegebenen Frequenzwert eines Wechselstroms, der durch das elektrisch leitende Material mit GMI-Effekt fließt, und dann
c) nach einer Zeitdauer, während der das Gerät (100) wahrscheinlich einem Angriff durch elektromagnetische Wellen ausgesetzt war, Messen eines zweiten Werts der Impedanz des Angriffserkennungselements (116), indem ein Wechselstrom mit einer Frequenz, die gleich dem gegebenen Wert ist, durch das elektrisch leitende Material mit GMI-Effekt fließen gelassen wird,
d) Vergleichen des ersten und zweiten Werts der Impedanz des Angriffserkennungselements (116), wobei davon ausgegangen wird, dass das Gerät (100) einen Angriff durch elektromagnetische Wellen erlitten hat, wenn der erste und zweite Wert der Impedanz des Angriffserkennungselements (116) signifikant voneinander verschieden sind.

2. Verfahren nach Anspruch 1, wobei Schritt a) durchgeführt wird, indem durch das elektrisch leitfähige GMI-Effektmaterial ein Erregungswechselstrom fließt, dessen Amplitude mit der Zeit allmählich abnimmt, oder indem das elektrisch leitfähige GMI-Effektmaterial einem magnetischen Erregungsfeld ausgesetzt wird, dessen Amplitude mit der Zeit allmählich abnimmt, bis der Wert der remanenten Magnetisierung des elektrisch leitfähigen GMI-Effektmaterials gleich dem vorbestimmten Wert ist.

3. Verfahren nach einem der vorstehenden Ansprüche, wobei der vorbestimmte Wert gleich dem Wert der minimalen remanenten Magnetisierung des elektrisch leitenden Materials mit GMI-Effekt ist.

4. Verfahren nach einem der Ansprüche 1 oder 2, wobei der vordefinierte Wert größer ist als der Wert der minimalen remanenten Magnetisierung des elektrisch leitenden Materials mit GMI-Effekt.

5. Verfahren nach einem der vorstehenden Ansprüche, wobei das elektrisch leitende Material mit GMI-Effekt ein weiches ferromagnetisches Material ist.

6. Verfahren nach einem der vorstehenden Ansprüche, wobei das Angriffserkennungselements (116) einen Sensor bildet, der an einem Teil einer Fläche (118) des Geräts (100) lokalisiert ist.

7. Verfahren nach Anspruch 6, wobei das Gerät (100) ferner mindestens ein Schutzelement (142) der Fläche (118) des Geräts (100) umfasst, wobei das Schutzelement (142) in dem Gerät (100) angeordnet ist und mindestens einen weiteren Abschnitt aus elektrisch leitendem Material mit GMI-Effekt umfasst, der sich in einer Ebene parallel zu der Fläche (118) des Geräts (100) gemäß mindestens einem Schlangen- und/oder Spiralmuster erstreckt.

8. Verfahren nach einem der vorstehenden Ansprüche, wobei das Gerät (100) ferner mindestens ein zweites Angriffserkennungselements (138) des Geräts (100) umfasst, das mindestens ein zweites elektrisch leitfähiges Material mit GMI-Effekt umfasst, und wobei die Schritte a), b), c) und d) des Verfahrens auch für das zweite Angriffserkennungselements (138) durchgeführt werden.

9. Verfahren nach den Ansprüchen 6 und 8 oder nach den Ansprüchen 7 und 8, wobei das erste und das zweite Angriffserkennungselements (116, 138) auf der Fläche (118) des Geräts (100) angeordnet sind.

## Claims

1. A method for detecting an attack by electromagnetic waves on an electronic chip or system-in-package type device (100) including at least one attack detection element (116) of the device (100), said attack detection element (116) including at least one giant magneto-impedance, GMI, effect electrically-conductive material, including at least the following steps:
a) demagnetising the GMI-effect electrically-conductive material such that the value M_{rd} of its remanent magnetisation is equal to a predefined value lower than the value of its maximum remanent magnetisation,
b) determining a first value of the impedance of the attack detection element (116) for a given value of the frequency of an alternating current circulating in the GMI-effect electrically-conductive material, then
c) after a time period during which the device (100) might have undergone an attack by electromagnetic waves, measuring a second value of the impedance of the attack detection element (116) by circulating in the GMI-effect electrically-conductive material an alternating current with a frequency equal to said given value,
d) comparing the first and second values of the impedance of the attack detection element (116), the device (100) being considered as having undergone an attack by electromagnetic waves when the first and second values of the impedance of the attack detection element (116) are significantly different from each other.

2. The method according to claim 1, wherein step a) is implemented by circulating in the GMI-effect electrically-conductive material an alternating excitation current whose amplitude progressively decreases over time or by subjecting the GMI-effect electrically-conductive material to a magnetic excitation field whose amplitude progressively decreases over time, until the value of the remanent magnetisation of the GMI-effect electrically-conductive material is equal to said predefined value.

3. The method according to one of the preceding claims, wherein the predefined value is equal to the value of the minimum remanent magnetisation of the GMI-effect electrically-conductive material.

4. The method according to one of claims 1 or 2, wherein the predefined value is higher than the value of the minimum remanent magnetisation of the GMI-effect electrically-conductive material.

5. The method according to one of the preceding claims, wherein the GMI-effect electrically-conductive material is a soft ferromagnetic material.

6. The method according to one of the preceding claims, wherein the attack detection element (116) forms a sensor located at a portion of a face (118) of the device (100).

7. The method according to claim 6, wherein the device (100) further includes at least one element (142) for protecting said face (118) of the device (100), said protective element (142) being disposed in the device (100) and comprising at least one other GMI-effect electrically-conductive material portion extending, in a plane parallel to said face (118) of the device (100), according to at least one serpentine and/or spiral like pattern.

8. The method according to one of the preceding claims, wherein the device (100) further includes at least one second attach detection element (138) of the device (100) comprising at least one second GMI-effect electrically-conductive material, and wherein steps a), b), c) and d) of the method are also implemented for the second attack detection element (138).

9. The method according to claims 6 and 8 or according to claims 7 and 8, wherein the first and second attack detection elements (116, 138) are disposed over said face (118) of the device (100).
